# EUROPEAN PATENT APPLICATION

(11) **EP 4 203 029 A2**
(43) Date of publication of application: **28.06.2023**
(21) Application number: 22205535.2
(22) Date of filing: 04.11.2022
(51) Int. Cl.: H01L 25/065, H01L 25/18, H01L 23/538, H01L 21/60, H01L 21/98

(54) **HYBRID BONDED STACKED MEMORY WITH TSV**

(30) Priority: 23.12.2021 US 202117561580
(71) Applicant: Intel Corporation, Santa Clara, CA 95054 (US)
(72) Inventor: Brun, Xavier F., Chandler, 85226 (US); Ganesan, Sanka, Chandler, 85248 (US); Mallik, Debendra, Chandler, 85226 (US)
(74) Representative: Goddar, Heinz J.

(57) **Abstract**

Embodiments disclosed herein include chiplet modules and die modules. In an embodiment, a chiplet module comprises a first chiplet, where the first chiplet comprises a first active surface. In an embodiment the chiplet module further comprises a second chiplet, where the second chiplet comprises a second active surface. In an embodiment, the chiplet module further comprises a hybrid bonding interface between the first chiplet and the second chiplet, where the hybrid bonding interface electrically couples the first chiplet to the second chiplet.

## Description

### TECHNICAL FIELD

Embodiments of the present disclosure relate to electronic packages, and more particularly to electronic packages with molded die modules with hybrid bonded stacked memory as a chiplet.

### BACKGROUND

As transistor density grows with each new silicon node, yielding large monolithic dies becomes extremely difficult. As such, there is a need for die disaggregation in cutting edge electronic packages. In one architecture, a plurality of dies are provided in a mold layer. Chiplets (e.g., bridge dies, and the like) can be provided in an additional mold layer below the plurality of dies. When bridge dies are used, the overlying dies may be electrically coupled together and the overlying dies may substantially function as a single larger die.

Having memory quickly accessible to the plurality of dies is also another challenge in large die modules, such as those described above. In one instance, cache memory (e.g., L1 and L2 cache) are part of the core design, and L3 cache is shared memory on the same monolithic active area. However, such architectures are limited because the distance between the cores and the L3 cache increases with increasing core count. This can impact latency, and may limit the growth of the die size. In another architecture, a hybrid bonding interconnect (HBI) is provided between an L3 memory chiplet and a through silicon via (TSV) core die. While such a solution may reduce active area footprint, such solutions require a large TSV logic die and may have yield challenges with increased core count.

### BRIEF DESCRIPTION OF THE DRAWINGS

Figure 1A is a cross-sectional illustration of a die module with memory chiplet modules provided directly under the footprint of processor dies, in accordance with an embodiment.
Figure 1B is a cross-sectional illustration of a die module with memory chiplet modules with a bottom chiplet that does not include TSVs, in accordance with an embodiment.
Figure 1C is a cross-sectional illustration of a die module with memory chiplet modules with three memory chiplets, in accordance with an embodiment.
Figure ID is a cross-sectional illustration of a die module with memory chiplet modules that include face-to-face memory chiplets, in accordance with an embodiment.
Figure 2A is a cross-sectional illustration of a chiplet module with a pair of chiplets that are bonded together with a hybrid bonding interconnect (HBI) architecture, in accordance with an embodiment.
Figure 2B is a cross-sectional illustration of a chiplet module with three chiplets that are bonded together with an HBI architecture, in accordance with an embodiment.
Figure 2C is a cross-sectional illustration of a chiplet module with chiplets that are bonded together in a face-to-face orientation with an HBI architecture, in accordance with an embodiment.
Figure 3 is a cross-sectional illustration depicting an HBI between a pair of chiplets, in accordance with an embodiment.
Figures 4A-4L are cross-sectional illustrations depicting a process for fabricating chiplet modules with HBI architectures, in accordance with an embodiment.
Figures 5A-5J are cross-sectional illustrations depicting a process for fabricating an electronic system with a die module that comprises chiplet modules that include HBI architectures, in accordance with an embodiment.
Figure 6 is a schematic of a computing device built in accordance with an embodiment.

### EMBODIMENTS OF THE PRESENT DISCLOSURE

Described herein are electronic packages with molded die modules with hybrid bonded stacked memory as a chiplet, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As used herein a "chiplet" or "tile" may refer to an integrated circuit (IC) die. In some implementations, a chiplet may be an IC die that is smaller and thinner than a typical microprocessor IC die and may provide specific circuitry and/or functionality. For example, in various implementations, a chiplet may provide memory or memory controller functionality. As noted above, memory integration with advanced packaging solutions is not without issue. Accordingly, embodiments disclosed herein include packaging architectures that provide memory chiplet modules directly below the logic in overlying processor dies. In a particular embodiment, the memory chiplet modules include a plurality of memory chiplets that are connected to each other with hybrid bonding interconnect (HBI) architectures. Accordingly, latency is reduced because the memory is located proximate to the logic. Furthermore, since the memory is not on the processor die, the inclusion of additional cores in the processor die does not move the memory further from the logic.

In a particular embodiment, memory chiplet modules comprise a first chiplet and a second chiplet. The two chiplets may be in a face-to-face orientation, with TSVs passing through the two chiplets. In an embodiment, the two chiplets are bonded with an HBI architecture. In another embodiment, two chiplets are coupled with a face-to-back orientation, but only the top chiplet includes TSVs. In such an embodiment, power may be provided to the memory chiplet module from above (i.e., from the die side). In yet another embodiment, a plurality of chiplets are stacked with HBI architectures. For example, three chiplets may be include in the memory chiplet module. Another embodiment may include two chiplets that are bonded with an HBI architecture, where the two chiplets are in a face-to-face orientation. As those skilled in the art will recognize, there are many different orientations and configurations that may be used in association with embodiments disclosed herein. However, each of the embodiments may include a memory chiplet module with chiplets that are bonded together with an HBI architecture.

Embodiments disclosed herein include several different levels of integration. For example, a first level of integration may be the memory chiplet module by itself. In another level of integration, the memory chiplet module may be integrated into a larger die module. For example, the memory chiplet modules may be provided below processor dies that are coupled to each other by one or more bridge dies. In yet another level of integration, a die module that includes one or more memory chiplets may be integrated into an electronic package or an electronic system. Additionally, it is to be appreciated that the terms "die" and "chiplet" are both used herein. It is to be appreciated that both dies and chiplets may include active circuitry, including transistors and the like. When compared to each other directly, a "die" may have a larger footprint than a "chiplet". Though, it is to be appreciated that neither dies nor chiplets are defined as having a specific range of dimensions.

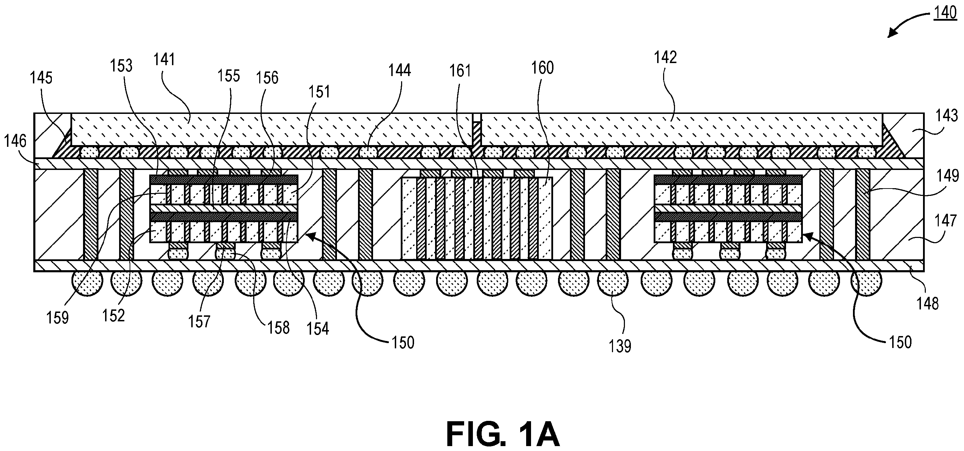

Referring now to Figure 1A, a cross-sectional illustration of a die module 140 is shown, in accordance with an embodiment. In an embodiment, the die module 140 may comprise a first die 141 and a second die 142. The first die 141 and the second die 142 may be processor dies or any other type of computational die. In an embodiment, the first die 141 and the second die 142 may be embedded in a first mold layer 143. The first die 141 and the second die 142 may be coupled to a redistribution layer 146 by interconnects 144. In an embodiment, the interconnects 144 may be any suitable interconnect architecture. In the illustrated embodiment, the interconnects 144 are solder bumps. An underfill 145 may surround the interconnects 144. The redistribution layer 146 may include conductive features (e.g., pads, traces, vias, etc.) that provides electrical routing between the interconnects 144 and underlying features in a second mold layer 147. The routing in the redistribution layer 146 is omitted for clarity, in order to not obscure aspects of certain embodiments disclosed herein.

In an embodiment, the second mold layer 147 is provided below the redistribution layer 146. In some embodiments conductive vias 149 may pass through a thickness of the second mold layer 147. For example, the conductive vias 149 may be copper pillars or the like. In an embodiment, a bridge die 160 is provided below the first die 141 and the second die 142. The bridge die 160 may include high density routing in order to electrically couple the first die 141 to the second die 142. TSVs 161 may also pass through the bridge die 160 (e.g., to provide power delivery).

In an embodiment, memory chiplet modules 150 may also be provided in the die module 140. The memory chiplet modules 150 may each be located below logic within the first die 141 or the second die 142. In a particular embodiment, the memory chiplet modules 150 may be L3 cache memory. In one embodiment, the memory chiplet modules 150 may comprise memory and a memory controller. For example, a first chiplet 151 may be a memory controller, and a second chiplet 152 may be the L3 cache memory. In other embodiments, the memory controller may be implemented on the overlying dies 141 or 142, and both the first chiplet 151 and the second chiplet 152 may be L3 cache.

In the illustrated embodiment, the memory chiplet modules 150 comprise two or more memory chiplets. For example, two memory chiplets 151 and 152 are shown in Figure 1A. The memory chiplets 151 and 152 may be provided in a face-to-back orientation. That is the active surface 153 of the first chiplet 151 faces away from the second chiplet 152, and the active surface 154 of the second chiplet 152 faces toward the first chiplet 151. In an embodiment, TSVs 159 may pass through the first chiplet 151 and the second chiplet 152.

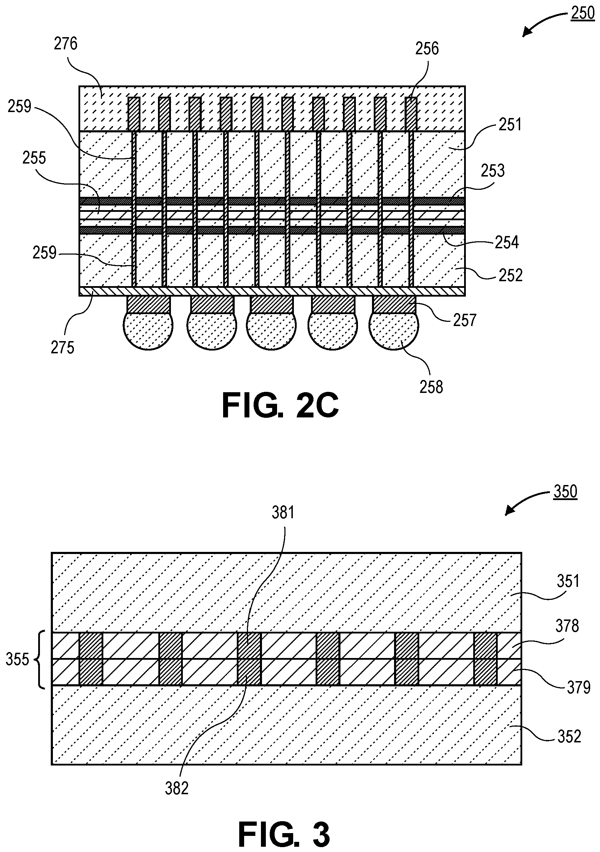

In an embodiment, the first chiplet 151 may be electrically and mechanically coupled to the second chiplet 152 with an HBI layer 155. The HBI layer 155 may include a pair of layers with each layer comprising conductive features and a dielectric layer around the conductive features. The conductive features on opposing layers bond together, and the dielectric layers bond together as well. In some embodiments, the conductive features are the TSVs 159. A more detailed description of the HBI interface is provided below with respect to Figure 3.

In an embodiment, the memory chiplet modules 150 may be coupled to the redistribution layer 146 by pads 156. In some instances a solder may be provided between the pads 156 and the redistribution layer 146. Additionally, the backside of the memory chiplet module 150 may be coupled to a second redistribution layer 148 below the mold layer 147 by pads 157 and solder 158. The backside connection to the second redistribution layer 148 may provide power to the memory chiplet modules 150. In an embodiment, the second redistribution layer 148 may include conductive routing (not shown), in order to couple conductive features in the second mold layer 147 (e.g., vias 149, solder 158, etc.) to interconnects 139. Interconnects 139 may be solder bumps or the like.

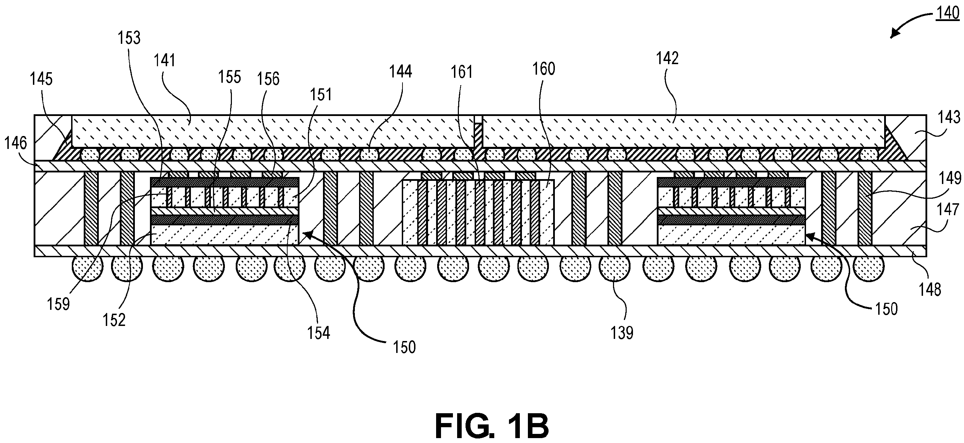

Referring now to Figure 1B, a cross-sectional illustration of a die module 140 is shown, in accordance with an additional embodiment. The die module 140 in Figure 1B may be substantially similar to the die module 140 in Figure 1A, with the exception of the architecture of the memory chiplet modules 150. Particularly, the second chiplet 152 does not include TSVs 159. In such an embodiment, there may not be backside electrical connections to the second redistribution layer 148. Instead, the backside of the second chiplet 152 may rest directly on the second redistribution layer 148. In such an embodiment, power may be provided to the memory chiplet modules 150 from the front sides of the memory chiplet modules 150.

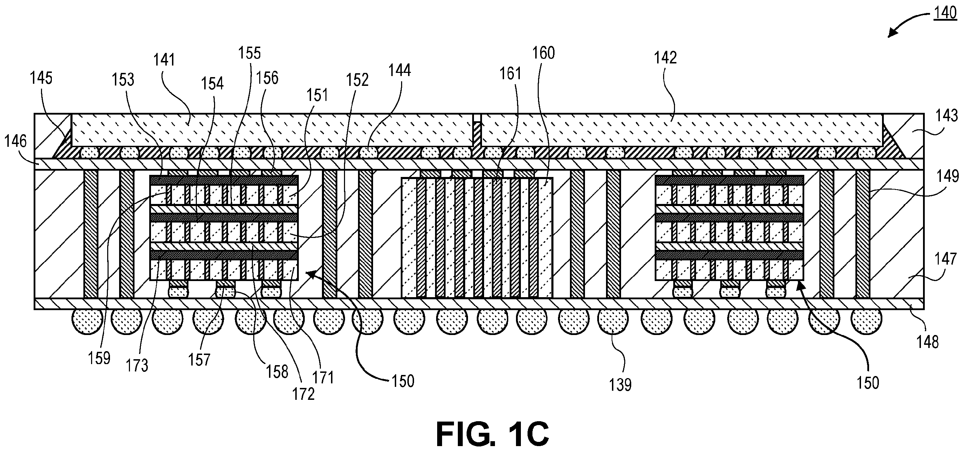

Referring now to Figure 1C, a cross-sectional illustration of a die module 140 is shown, in accordance with an additional embodiment. The die module 140 in Figure 1C may be substantially similar to the die module 140 in Figure 1A, with the exception of the architecture of the memory chiplet modules 150. Instead of having only two chiplets 151 and 152, the embodiment shown in Figure 1C includes three chiplets 151, 152, and 171. While three stacked chiplets are shown, it is to be appreciated that any number of chiplets may be stacked to form the memory chiplet modules 150.

In an embodiment, the third chiplet 171 may have an active face 173. The active face 173 may be oriented so that it is facing the second chiplet 152. In an embodiment, the third chiplet 171 is electrically and mechanically bonded to the second chiplet 152 by an HBI interface 172. A backside of the third chiplet 171 may be coupled to the second redistribution layer 148 by the pads 157 and solder 158.

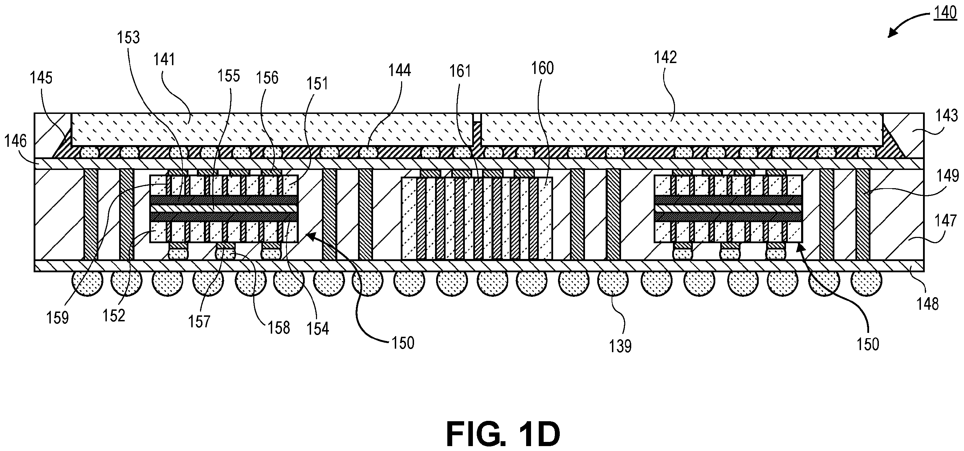

Referring now to Figure 1D, a cross-sectional illustration of a die module 140 is shown, in accordance with an additional embodiment. The die module 140 in Figure 1D may be substantially similar to the die module 140 in Figure 1A, with the exception of the architecture of the memory chiplet modules 150. Instead of having a face-to-back configuration, the memory chiplets 151 and 152 have a face-to-face orientation. That is, the active surface 153 of the first chiplet 151 faces towards the active surface 154 of the second chiplet 152, and the active surface 154 of the second chiplet 152 faces towards the active surface 153 of the first chiplet 151.

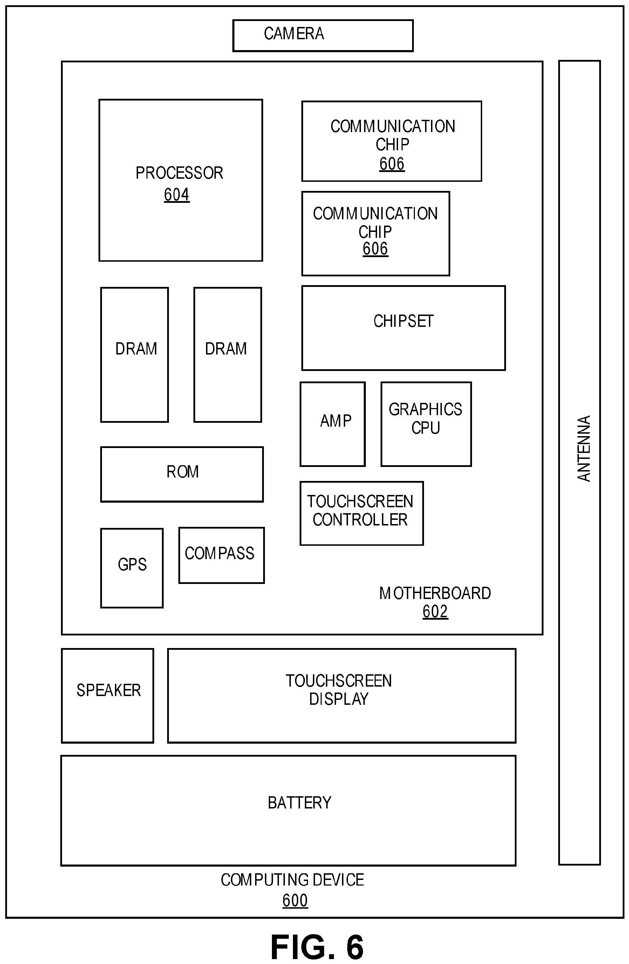

In Figures 1A-11D, various chiplet orientations are shown. However, it is to be appreciated that the chiplets (e.g., chiplets 151 and 152) may have any orientation. For example, the active surfaces of the chiplets 151 and 152 may face each other, the active surfaces may face in the same direction (e.g., both chiplets 151 and 152 face the top dies 141/142 or both chiplets 151 and 152 face down), or the chiplets 151 and 152 may face away from each other (i.e., in a back-to-back orientation). Generally speaking, the stacked chiplets (e.g., two or more chiplets) may independently face up or down (i.e., towards the top die or away from the top die in any combination). Additionally, the stacked chiplets may be fully under one of the top dies, or the stacked chiplets may straddle between a pair of top dies.

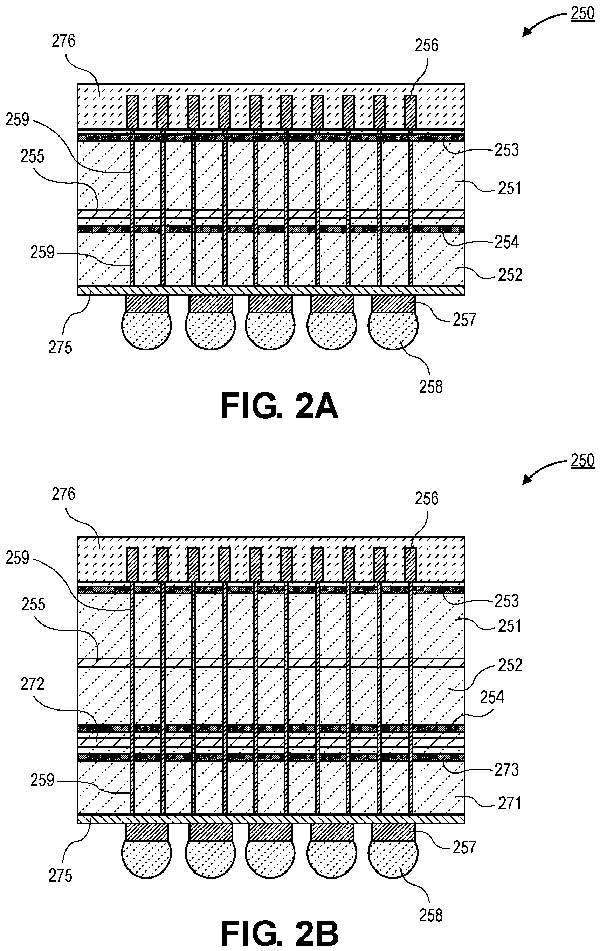

Referring now to Figures 2A-2C, more detailed illustrations of the memory chiplet modules 250 are shown, in accordance with various embodiments. It is to be appreciated that any of the embodiments shown in Figures 2A-2C may be integrated into a die module 140, such as those described in greater detail above.

Referring now to Figure 2A, a cross-sectional illustration of a memory chiplet module 250 is shown, in accordance with an embodiment. As shown, the memory chiplet module 250 may comprise a first chiplet 251 and a second chiplet 252. The first chiplet 251 may be electrically and mechanically coupled to the second chiplet 252 by an HBI interface layer 255. The conductive features of the HBI interface layer 255 may be portions of the TSVs 259. That is, the TSVs 259 of the first chiplet 251 may be coupled to the TSVs 259 of the second chiplet 252. A dielectric material (e.g., SiO₂) may surround the TSVs 259 in the HBI interface layer 255.

In an embodiment, the first chiplet 251 may have an active surface 253, and the second chiplet 252 may have an active surface 254. The first chiplet 251 and the second chiplet 252 may have a face-to-back orientation with each other. That is, the active surface 253 of the first chiplet 251 faces away from the second chiplet 252, and the active surface 254 of the second chiplet 252 faces toward the first chiplet 251.

In an embodiment, the TSVs 259 may be coupled to pads 256 over the first chiplet 251. The pads 256 may be embedded in a mold layer 276 in some instances. In an embodiment, the backside of the second chiplet 252 may be coupled to pads 257 and solder 258. The backside of the TSVs 259 may terminate at a redistribution layer 275. The redistribution layer 275 may comprise conductive routing (not shown), that couples the TSVs 259 to the pads 257.

Referring now to Figure 2B, a cross-sectional illustration of a memory chiplet module 250 is shown, in accordance with an additional embodiment. In an embodiment, the memory chiplet module 250 in Figure 2B is substantially similar to the memory chiplet module 250 in Figure 2A, with the addition of another memory chiplet 271. That is, instead of two chiplets, three chiplets 251, 252, and 271 are provided in the memory chiplet module 250. While three chiplets are shown, it is to be appreciated that any number of chiplets may be stacked in the chiplet module 250.

In an embodiment, the third chiplet 271 may be electrically and mechanically bonded to the second chiplet 252 by an HBI layer 272. The HBI layer 272 may be substantially similar to the HBI layer 255 described above. In an embodiment, the second chiplet 252 and the third chiplet 271 may be oriented in a face-to-face positioning. That is, the active surface 254 of the second chiplet 252 faces the third chiplet 271, and the active surface 273 of the third chiplet 271 faces the second chiplet 252. Such a configuration may result in the first chiplet 251 and the second chiplet 252 having a back-to-back orientation with respect to each other.

Referring now to Figure 2C, a cross-sectional illustration of a memory chiplet module 250 is shown, in accordance with an additional embodiment. In an embodiment, the memory chiplet module 250 in Figure 2C may be substantially similar to the memory chiplet module 250 in Figure 2A, with the exception of the orientation of the first chiplet 251. Instead of having a face-to-back orientation with the second chiplet 252, the first chiplet 251 is in a face-to-face orientation with the second chiplet 252. That is, the active surface 253 of the first chiplet 251 faces the second chiplet 252, and the active surface 254 of the second chiplet 252 faces the first chiplet 251.

Referring now to Figure 3, a cross-sectional illustration of a portion of a memory chiplet module 350 is shown, in accordance with an embodiment. The illustration shows a more detailed illustration of the HBI layer 355. As shown, first conductors 381 are provided on the first chiplet 351. A first dielectric layer 378 surrounds the first conductors 381. Second conductors 382 and a second dielectric layer 379 are provided on the opposing surface of the second chiplet 352. At low temperatures, the first dielectric layer 378 and the second dielectric layer 379 bond together. At higher temperatures, the first conductors 381 bond with the second conductors 382 with a solid state diffusion process. In some embodiments, the solid state diffusion may result in there not being a visible seam between the first conductors 381 and the second conductors 382. In an embodiment, the first conductors 381 and the second conductors 382 may be part of the TSVs through the first chiplet 351 and the second chiplet 352.

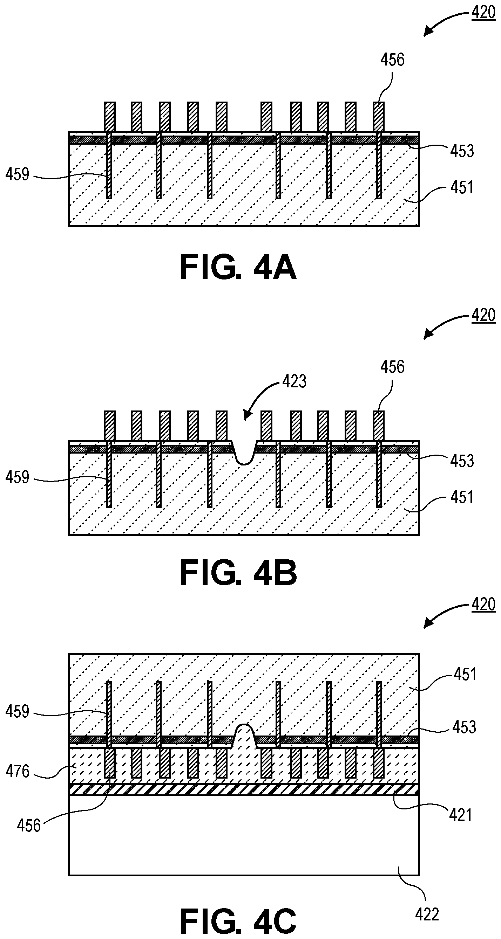

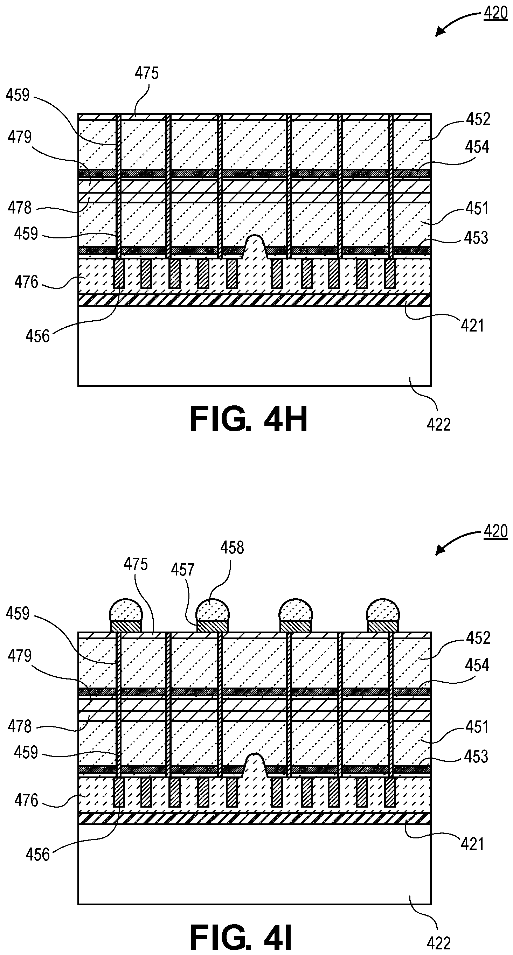

Referring now to Figures 4A-4L, a series of cross-sectional illustrations depicting a process for forming a memory chiplet module is shown, in accordance with an embodiment. In the illustrated embodiment, the memory chiplet modules are formed from a wafer 420. That is, a plurality of memory chiplet modules may be made in parallel (assembled and tested in wafer form to sort known good memory chiplet modules) and singulated at the end in order to provide known good individual memory chiplet modules.

Referring now to Figure 4A, a cross-sectional illustration of a wafer 420 is shown, in accordance with an embodiment. As shown, first chiplets 451 are provided with an active surface 453. TSVs 459 may pass through a thickness of the chiplet 451. The TSVs 459 may not pass entirely through a thickness of the chiplet 451 in some embodiment. In an embodiment, pads 456 may be provided over a top surface of the chiplets 451.

Referring now to Figure 4B, a cross-sectional illustration of the wafer 420 after a recess 423 is formed into the top surface of the chiplets 451 is shown, in accordance with an embodiment. In some instances the recess 423 may be referred to as a groove and/or a kerf. In an embodiment, the recess 423 may be provided between adjacent chiplets 451 in the wafer 420. The recess 423 may extend through the active surface 453 and partially into the underlying substrate of the chiplets 451. In an embodiment, the recess 423 may be formed with a laser scribing process.

Referring now to Figure 4C, a cross-sectional illustration of the wafer 420 after it is coupled to carrier 422 is shown, in accordance with an embodiment. Prior to bonding the wafer 420 to the carrier 422, the pads 456 may be surrounded by a mold layer 476. After the molding, the mold layer 476 may be secured to the carrier 422. The carrier 422 may be any suitable rigid material. For example, the carrier 422 may comprise glass. In an embodiment, an adhesive 421 may secure the mold layer 476 to the carrier 422. Any adhesive material typically used for securing substrates to carriers 422 may be used. As illustrated, the wafer 420 is flipped over for bonding to the carrier 422.

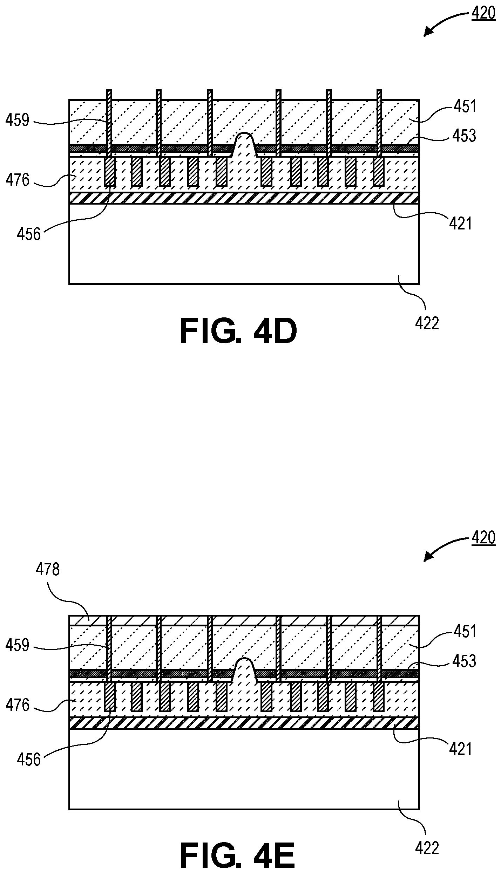

Referring now to Figure 4D, a cross-sectional illustration of the wafer 420 after a backside recess is shown, in accordance with an embodiment. In an embodiment, the backside recessing operation may result in the chiplets 451 being thinned. The chiplets 451 are thinned so that ends of the TSVs 459 are exposed. The recessing operation may include a grinding process (e.g., chemical mechanical polishing (CMP)) and an etching process. For example, the grinding process may be used to expose the top surfaces of the TSVs 459, and the etching process may selectively recess the chiplets 451 in order to expose sidewalls of the TSVs 459.

Referring now to Figure 4E, a cross-sectional illustration of the wafer 420 after a dielectric layer 478 is disposed over the backside of the chiplets 451 is shown, in accordance with an embodiment. In an embodiment, the dielectric layer 478 may be a material that is suitable for hybrid bonding applications. For example, the dielectric layer 478 may comprise SiN, SiCN, or SiO₂. In an embodiment, the deposition process may be implemented with any suitable deposition process. In a particular embodiment, the deposition process may include physical vapor deposition (PVD) or plasma-enhanced PVD (PECVD). After deposition of the dielectric layer 478 a CMP process may be used to expose that top surfaces of the TSVs 459.

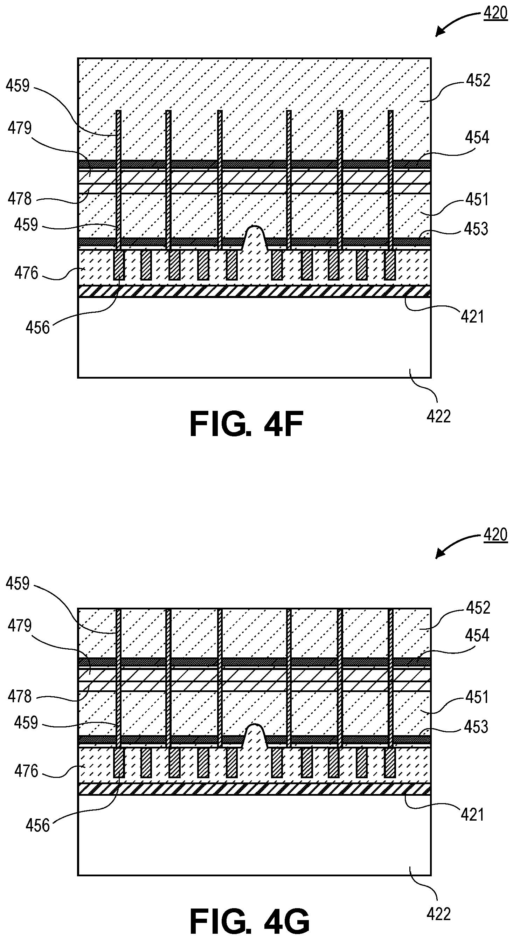

Referring now to Figure 4F, a cross-sectional illustration of the wafer 420 after second chiplets 452 are disposed over the first chiplets 451. In an embodiment, the second chiplets 452 comprise an active surface 454 and TSVs 459. Ends of the TSVs 459 may be surrounded by a dielectric layer 479. The dielectric layer 479 may be substantially similar to the dielectric layer 478. As such, the necessary layers are provided for a hybrid bonding connection between the first chiplets 451 and the second chiplets 452. For example, the dielectric layer 478 bonds to the dielectric layer 479 at low temperatures. At a higher temperature the TSVs 459 of the first chiplets 451 are bonded to the TSVs 459 of the second chiplets 452 with a solid state diffusion process.

In the illustrated embodiment, the first chiplets 451 and the second chiplets 452 are bonded together in a back-to-front orientation. However, it is to be appreciated that substantially similar processing operations may be used to provide front-to-front or back-to-back orientations as well. For example, any of the configurations described in greater detail above may be assembled with similar hybrid bonding processes.

In Figure 4F, only the first chiplets 451 includes a recess 423. However, it is to be appreciated that the second chiplets 452 may also include a recess through the active surface 454. In other embodiments, only the second chiplets 452 may include the recess 423. In yet another embodiment, neither the first chiplets 451 nor the second chiplets 452 comprise a recess 423.

Referring now to Figure 4G, a cross-sectional illustration of the wafer 420 after a grinding process is shown, in accordance with an embodiment. As shown, the backside surface of the second chiplets 452 are recessed to expose the TSVs 459. In an embodiment, the recessing operation may be a grinding, polishing, and/or etching process.

Referring now to Figure 4H, a cross-sectional illustration of the wafer 420 after a redistribution layer 475 is formed over and around the ends of the TSVs 459 on the backside of the second chiplets 452 is shown, in accordance with an embodiment. In an embodiment, the redistribution layer 475 may comprise conductive routing (not shown) in order to redistribute the positioning of the TSVs 459. While shown as a single layer, it is to be appreciated that any number of redistribution layers 475 may be used in accordance with various embodiments.

Referring now to Figure 41, a cross-sectional illustration of the wafer 420 after pads 457 and solder 458 is disposed over the backside of the second chiplets 452 is shown, in accordance with an embodiment. In an embodiment, the pads 457 may be coupled to the TSVs 459 through the redistribution layer 475. The pads 457 and the solder 458 may be referred to as package side bumps since they will be facing the package substrate when integrated into a die module similar to those described in greater detail above. The pads 457 may comprise copper and the solder 458 may comprise an alloy of tin and silver, though other materials may be used in different embodiments.

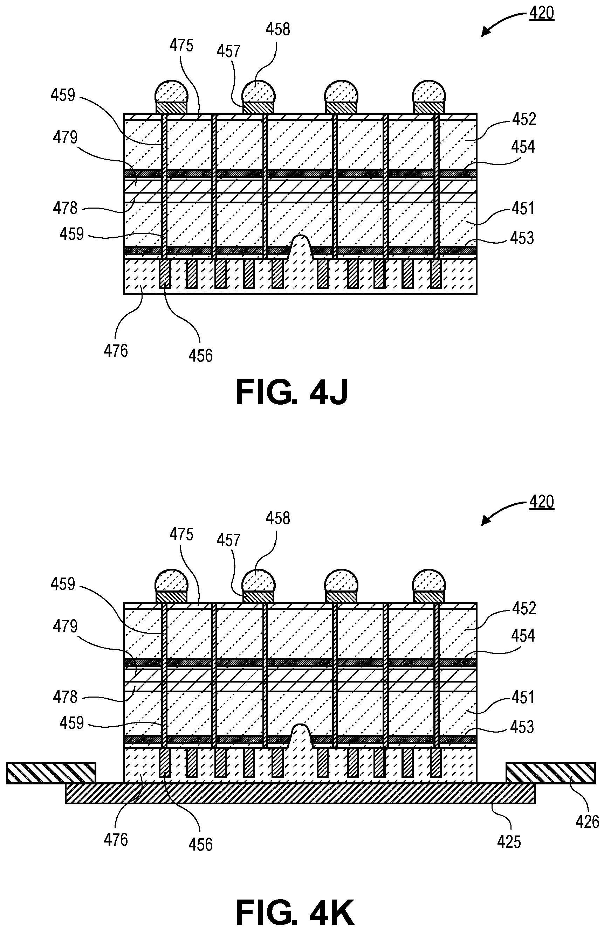

Referring now to Figure 4J, a cross-sectional illustration of the wafer 420 after the carrier 422 is released is shown, in accordance with an embodiment. In an embodiment, the carrier 422 may be released by deactivating the adhesive 421. For example, in some instances an ultra-violet light is propagated through the carrier 422. The ultra-violet light weakens the adhesive and allows for the wafer 420 to be released. Though, it is to be appreciated that other release mechanisms may also be used. For example, a thermally deactivated adhesive may also be used in some embodiments.

Referring now to Figure 4K, a cross-sectional illustration of the wafer 420 after it is placed on a frame 426 is shown, in accordance with an embodiment. In an embodiment, the frame 426 may further comprise a film 425 on which the wafer 420 is supported.

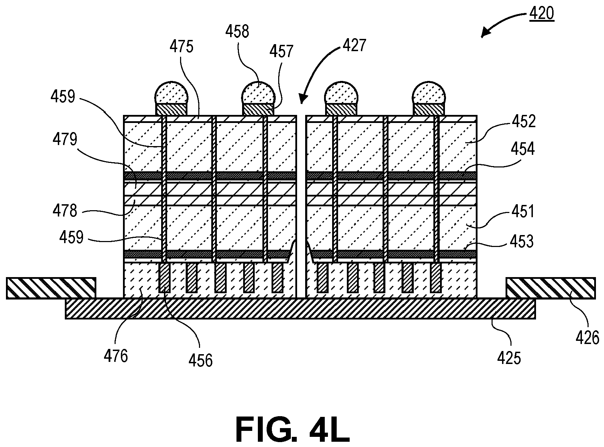

Referring now to Figure 4L, a cross-sectional illustration of the wafer 420 after it has been singulated is shown, in accordance with an embodiment. In an embodiment, the singulation may be a laser scribing process. In other embodiments, a mechanical sawing process may be used. The singulation line 427 may be aligned with the notch formed in the initial stages of manufacture. After singulating, the individual chiplet modules may be tested before being integrated into a die module. However, in other embodiments, the chiplet modules may be tested before singulation at the wafer stage.

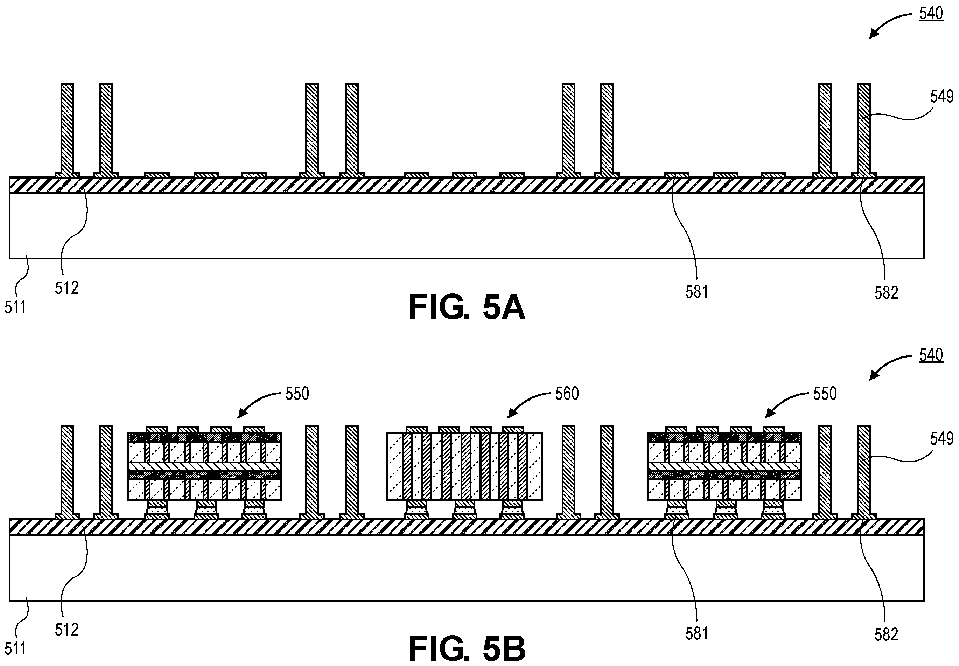

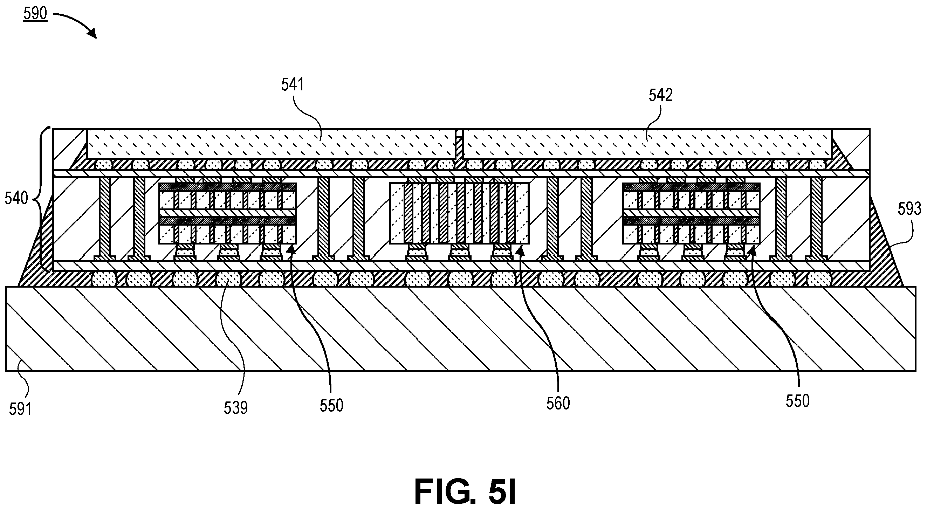

Referring now to Figures 5A-5J, a series of cross-sectional illustrations depicting a process for forming a die module with memory chiplet modules below the processor dies is shown, in accordance with an embodiment. The illustrated embodiment may be referred to as a top die last approach, since the top dies are attached to the module after the underlying chiplet modules are attached. However, those skilled in the art will appreciate that process flows can also be formed with a top die first approach.

Referring now to Figure 5A, a cross-sectional illustration of a die module 540 is shown, in accordance with an embodiment. As shown, the die module 540 may comprise pads 581 and pads 582. The pads 582 may be under conductive pillars 549, such as copper pillars. In an embodiment, the pads 581 are left exposed. The pads 581 and 582 may be provided over an adhesive layer 512. The adhesive layer 512 may couple the features, and subsequently added features to a carrier 511. For example, the carrier 511 may be a glass carrier or the like.

Referring now to Figure 5B, a cross-sectional illustration of the die module 540 after chiplet modules 550 and bridge dies 560 are mounted to the pads 581 is shown, in accordance with an embodiment. In an embodiment, the chiplet modules 550 may be memory chiplet modules 550. That is, the chiplet modules may include one or more memory chiplets within the stack. A memory controller may also be included in the chiplet modules 550 in some embodiments. Generally, the memory chiplet modules may be substantially similar to any of the chiplet modules described in greater detail above. The bridge die 560 may include high density routing in order to couple the first top die to the second top die. The first top die and the second top die are added in subsequent processing operations, as will be described below.

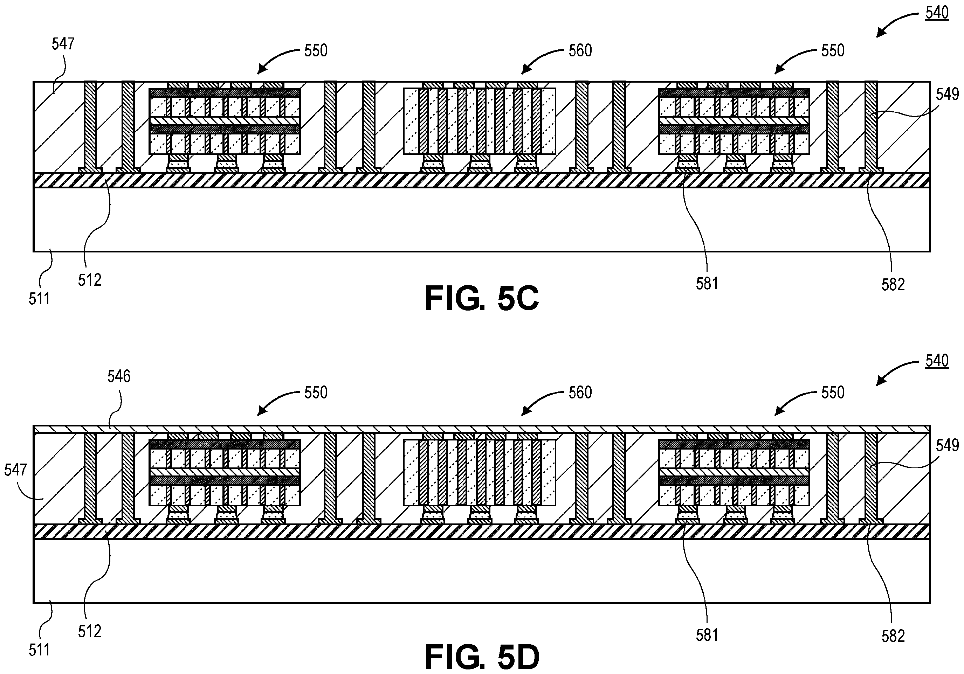

Referring now to Figure 5C, a cross-sectional illustration of the die module 540 after a mold layer 547 is disposed around the pillars 549, the chiplet modules 550, and the bridge die 560 is shown, in accordance with an embodiment. In an embodiment, the mold layer 547 may be disposed to a thickness greater than the height of the pillars 549. The mold layer 547 may then be recessed (e.g., with a grinding process or polishing process, such as CMP).

Referring now to Figure 5D, a cross-sectional illustration of the die module 540 after a redistribution layer 546 is formed over the mold layer 547 is shown, in accordance with an embodiment. In an embodiment, the redistribution layer 546 may comprise any number of layers of conductive features (not shown) that provide routing to redistribute the top pads and pillars 549.

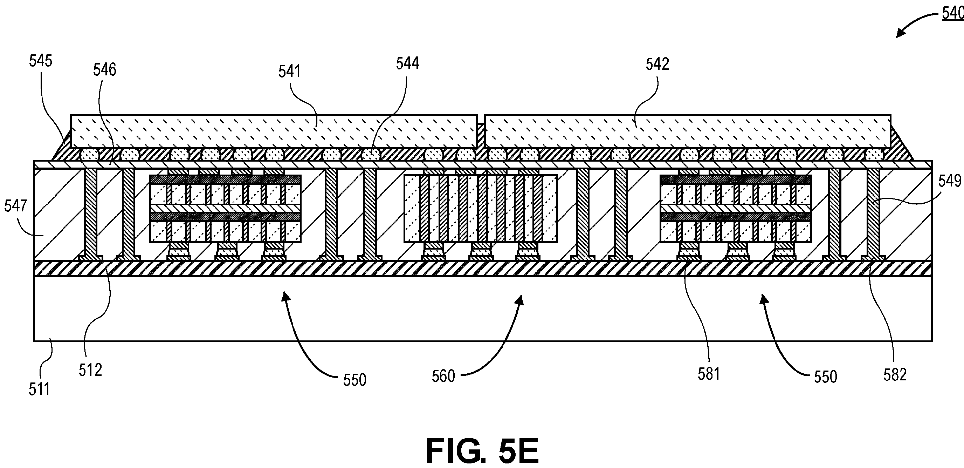

Referring now to Figure 5E, a cross-sectional illustration of the die module 540 after the first top die 541 and the second top die 542 are attached is shown, in accordance with an embodiment. The first top die 541 and the second top die 542 may be any suitable computation dies. For example, the first top die 541 and the second top die 542 may be processors, graphics processors, SoCs, or the like. In an embodiment, the first top die 541 may be electrically coupled to the second top die 542 by the bridge die 560. Additionally, a first memory chiplet module 550 may be provided within a footprint of the first top die 541, and a second memory chiplet module 550 may be provided within a footprint of the second top die 542. The memory chiplet modules 550 may be provided below logic within the top dies 541 and 542. In a particular embodiment, the memory chiplet modules 550 provide L3 cache to the top dies 541 and 542. In an embodiment, an underfill 545 may surround interconnects 544 used to connect the top dies 541 and 542 to the redistribution layer 546.

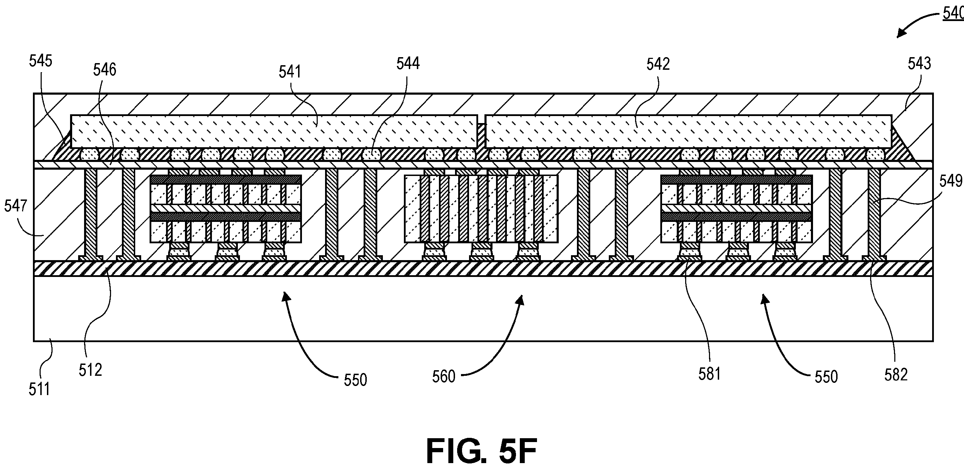

Referring now to Figure 5F, a cross-sectional illustration of the die module 540 after a top mold layer 543 is deposited is shown, in accordance with an embodiment. In an embodiment, the top mold layer 543 may surround the top dies 541 and 542.

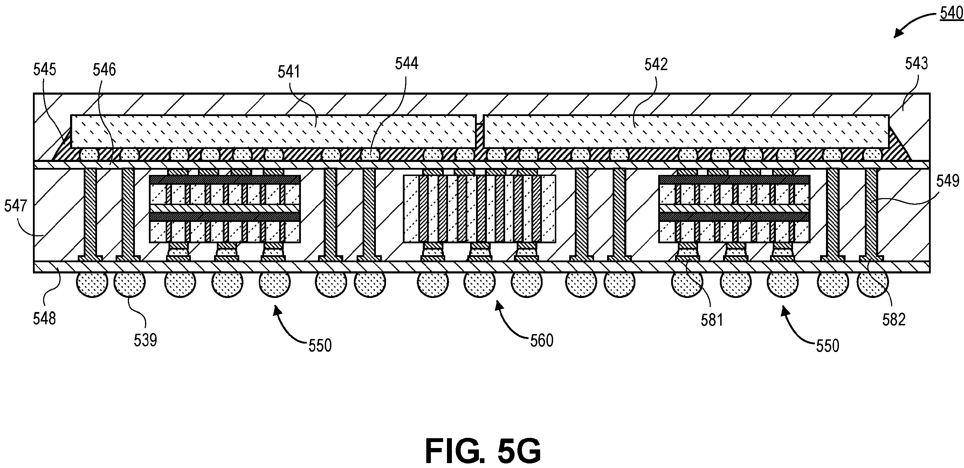

Referring now to Figure 5G, a cross-sectional illustration of the die module 540 after the carrier 511 is removed is shown, in accordance with an embodiment. The carrier 511 may be removed by deactivating the adhesive layer 512. For example, the adhesive layer may be deactivated by UV exposure through the carrier 511. In other embodiments, a thermal process may be used to release the carrier 511.

After removal of the carrier 511, a second redistribution layer 548 may be provided over a bottom surface of the mold layer 547. The second redistribution layer 548 may couple pads 581 and 582 to interconnects 539 with one or more layers of conductive routing (not shown). The interconnects 539 may comprise solder balls or the like.

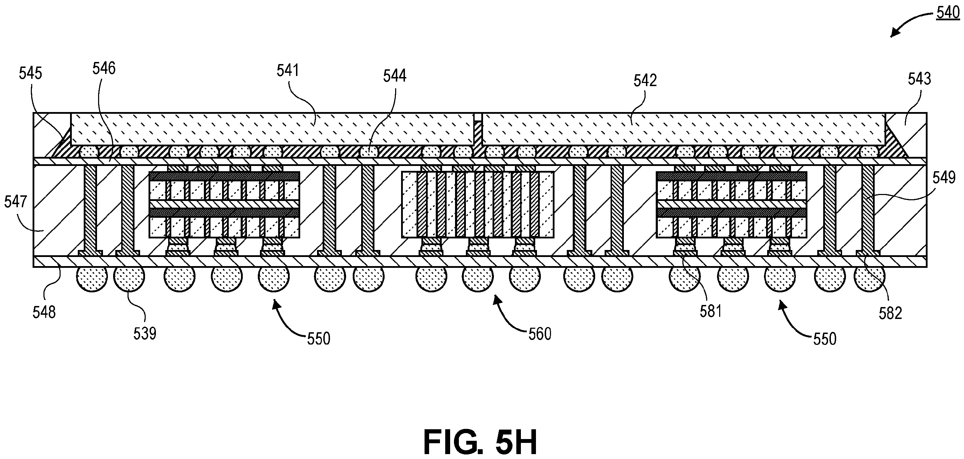

Referring now to Figure 5H, a cross-sectional illustration of the die module 540 after the top mold layer 543 is recessed is shown, in accordance with an embodiment. In an embodiment, the top mold layer 543 may be recessed with a grinding process or the like. The grinding process exposes the backside surface of the top dies 541 and 542. In some embodiments, the grinding process may also reduce the thickness of the top dies 541 and 542.

Referring now to Figure 51, a cross-sectional illustration of an electronic package 590 is shown, in accordance with an embodiment. As shown, a die module 540 is coupled to a package substrate 591 by the interconnects 539. An underfill material 593 may extend up sidewalls of the die module 540 and surround the interconnects 539.

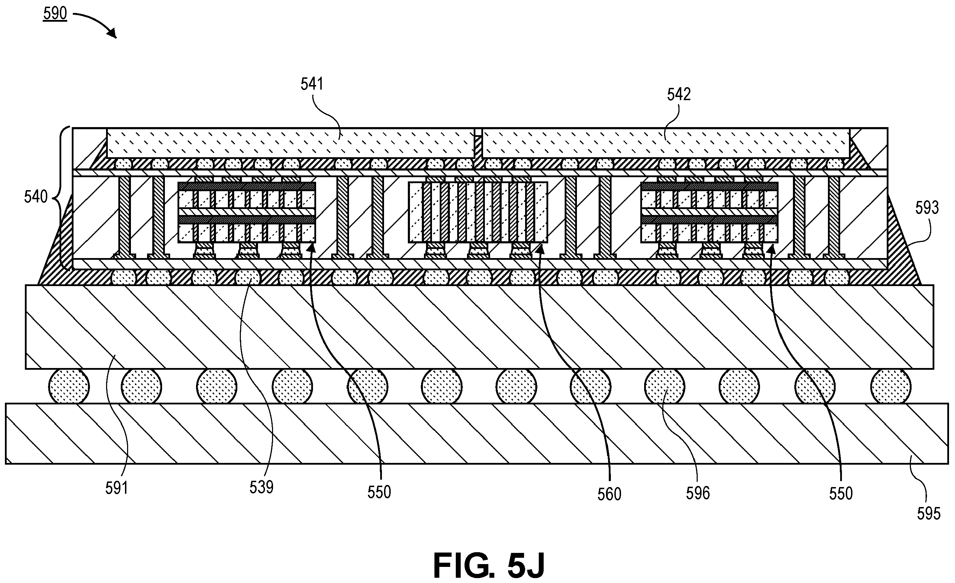

Referring now to Figure 5J, a cross-sectional illustration of an electronic package 590 is shown, in accordance with an additional embodiment. In addition to the package substrate 591, the die module 540 may further be coupled to a board 595, such as a printed circuit board (PCB). The package substrate 591 may be coupled to the board 595 by interconnects 596. While shown as solder balls, it is to be appreciated that the interconnects 596 may be any suitable interconnect architecture such as sockets or the like.

Figure 12 illustrates a computing device 1200 in accordance with one implementation of the invention. The computing device 1200 houses a board 1202. The board 1202 may include a number of components, including but not limited to a processor 1204 and at least one communication chip 1206. The processor 1204 is physically and electrically coupled to the board 1202. In some implementations the at least one communication chip 1206 is also physically and electrically coupled to the board 1202. In further implementations, the communication chip 1206 is part of the processor 1204.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1206 enables wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1206 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1200 may include a plurality of communication chips 1206. For instance, a first communication chip 1206 may be dedicated to shorter range wireless communications such as Wi-Fi and Bluetooth and a second communication chip 1206 may be dedicated to longer range wireless communications such as GPS, EDGE, GPRS, CDMA, WiMAX, LTE, Ev-DO, and others.

The processor 1204 of the computing device 1200 includes an integrated circuit die packaged within the processor 1204. In some implementations of the invention, the integrated circuit die of the processor may be part of an electronic package that comprises a die module that comprises top dies and memory chiplet modules below the top dies to provide an L3 cache to the overlying top dies, in accordance with embodiments described herein. The term "processor" may refer to any device or portion of a device that processes electronic data from registers and/or memory to transform that electronic data into other electronic data that may be stored in registers and/or memory.

The communication chip 1206 also includes an integrated circuit die packaged within the communication chip 1206. In accordance with another implementation of the invention, the integrated circuit die of the communication chip may be part of an electronic package that comprises a die module that comprises top dies and memory chiplet modules below the top dies to provide an L3 cache to the overlying top dies, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a chiplet module, comprising: a first chiplet, wherein the first chiplet comprises a first active surface; a second chiplet, wherein the second chiplet comprises a second active surface; and a hybrid bonding interface between the first chiplet and the second chiplet, wherein the hybrid bonding interface electrically couples the first chiplet to the second chiplet.

Example 2: the chiplet module of Example 1, wherein the first active surface faces away from the second active surface.

Example 3: the chiplet module of Example 1, wherein the first active surface faces toward the second active surface.

Example 4: the chiplet module of Examples 1-3, wherein the first chiplet is a memory controller, and wherein the second chiplet is a memory chiplet.

Example 5: the chiplet module of Examples 1-3, wherein the first chiplet is a memory chiplet, and wherein the second chiplet is a memory chiplet.

Example 6: the chiplet module of Examples 1-5, further comprising: first through substrate vias through the first chiplet.

Example 7: the chiplet module of Example 6, further comprising second through substrate vias through the second chiplet, wherein the hybrid bonding interface electrically couples the first through substrate vias to the second through substrate vias.

Example 8: the chiplet module of Example 7, further comprising: a redistribution layer over a backside surface of the second chiplet; and solder interconnects over the redistribution layer.

Example 9: the chiplet module of Examples 1-8, further comprising: a third chiplet wherein the third chiplet comprises a third active surface; and a second hybrid bonding interface between the second chiplet and the third chiplet.

Example 10: the chiplet module of Example 9, wherein the first chiplet and the second chiplet are oriented back-to-back, and wherein the second chiplet and the third chiplet are oriented face-to-face.

Example 11: the chiplet module of Examples 1-10, wherein an orientation of the first chiplet is independent of the orientation of the second chiplet so that the first chiplet may face up or down, and the second chiplet may face up or down.

Example 12: the chiplet module of Examples 1-11, wherein the hybrid bonding interface comprises: first pads on the first chiplet; a first dielectric layer around the first pads; second pads on the second chiplet; and a second dielectric layer around the second pads, wherein the first pads are bonded to the second pads, and wherein the first dielectric layer is bonded to the second dielectric layer.

Example 13: a die module, comprising: a first die in a first mold layer; a second die in the first mold layer; a first chiplet module in a second mold layer, wherein the first chiplet module is within a footprint of the first die; and a second chiplet module in the second mold layer, wherein the second chiplet module is within a footprint of the second die.

Example 14: the die module of Example 13, wherein the first chiplet module and the second chiplet module both comprise stacked memory chiplets.

Example 15: the die module of Example 14, wherein the stacked memory chiplets are coupled together by hybrid bonding interfaces.

Example 16: the die module of Example 14 or Example 15, wherein the stacked memory chiplets are oriented with active surfaces facing away from each other.

Example 17: the die module of Example 14 or 15, wherein the stacked memory chiplets are oriented with active surfaces facing each other.

Example 18: the die module of Examples 14-17, wherein the stacked memory chiplets comprise through substrate vias.

Example 19: the die module of Examples 13-18, further comprising: a bridge die in the second mold layer, wherein the bridge die couples the first die to the second die.

Example 20: the die module of Examples 13-19, further comprising: a redistribution layer between the first mold layer and the second mold layer.

Example 21: the die module of Examples 13-20 wherein backside surfaces of the first chiplet module and the second chiplet module are substantially coplanar with a surface of the second mold layer.

Example 22: the die module of Examples 13-21, further comprising: solder interconnects between backside surfaces of the first chiplet module and the second chiplet module and a surface of the second mold layer.

Example 23: the die module of Example 22, further comprising: a third chiplet module straddling between the first die and the second die.

Example 24: an electronic system, comprising: a board; a package substrate coupled to the board; and a die module coupled to the package substrate, wherein the die module comprises: a first die in a first mold layer; a second die in the first mold layer; a first chiplet module in a second mold layer, wherein the first chiplet module is within a footprint of the first die; and a second chiplet module in the second mold layer, wherein the second chiplet module is within a footprint of the second die.

Example 25: the electronic system of Example 24, wherein the first chiplet module and the second chiplet module both comprise: a first chiplet, wherein the first chiplet comprises a first active surface; a second chiplet, wherein the second chiplet comprises a second active surface; and a hybrid bonding interface between the first chiplet and the second chiplet, wherein the hybrid bonding interface electrically couples the first chiplet to the second chiplet.

## Claims

1. A chiplet module, comprising:
a first chiplet, wherein the first chiplet comprises a first active surface;
a second chiplet, wherein the second chiplet comprises a second active surface; and
a hybrid bonding interface between the first chiplet and the second chiplet, wherein the hybrid bonding interface electrically couples the first chiplet to the second chiplet.

2. The chiplet module of claim 1, wherein the first active surface faces away from the second active surface.

3. The chiplet module of claim 1, wherein the first active surface faces toward the second active surface.

4. The chiplet module of claim 1, 2 or 3, wherein the first chiplet is a memory controller, and wherein the second chiplet is a memory chiplet.

5. The chiplet module of claim 1, 2 or 3, wherein the first chiplet is a memory chiplet, and wherein the second chiplet is a memory chiplet.

6. The chiplet module of claim 1, 2, 3, 4 or 5, further comprising:
first through substrate vias through the first chiplet.

7. The chiplet module of claim 6, further comprising second through substrate vias through the second chiplet, wherein the hybrid bonding interface electrically couples the first through substrate vias to the second through substrate vias.

8. The chiplet module of claim 7, further comprising:
a redistribution layer over a backside surface of the second chiplet; and
solder interconnects over the redistribution layer.

9. The chiplet module of claim 1, 2, 3, 4, 5, 6, 7 or 8, further comprising:
a third chiplet wherein the third chiplet comprises a third active surface; and
a second hybrid bonding interface between the second chiplet and the third chiplet.

10. The chiplet module of claim 9, wherein the first chiplet and the second chiplet are oriented back-to-back, and wherein the second chiplet and the third chiplet are oriented face-to-face.

11. The chiplet module of claim 1, 2, 3, 4, 5, 6, 7, 8, 9 or 10, wherein an orientation of the first chiplet is independent of the orientation of the second chiplet so that the first chiplet may face up or down, and the second chiplet may face up or down.

12. The chiplet module of claim 1, 2, 3, 4, 5, 6, 7, 8, 9, 10 or 11, wherein the hybrid bonding interface comprises:
first pads on the first chiplet;
a first dielectric layer around the first pads;
second pads on the second chiplet; and
a second dielectric layer around the second pads, wherein the first pads are bonded to the second pads, and wherein the first dielectric layer is bonded to the second dielectric layer.

13. A method of fabricating a chiplet module, the method comprising:
providing a first chiplet, wherein the first chiplet comprises a first active surface;
providing a second chiplet, wherein the second chiplet comprises a second active surface; and
forming a hybrid bonding interface between the first chiplet and the second chiplet, wherein the hybrid bonding interface electrically couples the first chiplet to the second chiplet.

14. The method of claim 13, wherein the first active surface faces away from the second active surface.

15. The method of claim 13, wherein the first active surface faces toward the second active surface.
